# EUROPÄISCHE PATENTANMELDUNG

(11) **EP 0 973 203 A2**
(43) Veröffentlichungstag der Anmeldung: **19.01.2000**
(21) Anmeldenummer: 99113246.5
(22) Anmeldetag: 06.07.1999
(51) Int. Cl.: H01L 29/06

(54) **Halbleiterschicht mit lateral veränderlicher Dotierung und Verfahren zu dessen Herstellung**

(30) Priorität: 17.07.1998 US 93245 P
(71) Anmelder: SIEMENS AKTIENGESELLSCHAFT, 80333 München (DE)
(72) Erfinder: Deboy, Gerald, Dr., 82008 Unterhaching (DE); Werner, Wolfgang, Dr., 81545 München (DE)

(57) **Zusammenfassung**

Die vorliegende Erfindung betrifft eine Halbleiterschicht mit lateral veränderlicher Dotierung und ein Verfahren zu dessen Herstellung. Die Gräben werden hier nicht mehr vollständig mit dotiertem Halbleitermaterial aufgefüllt. Es wird vielmehr eine dotierte Ausräumschicht gewissermaßen als Belag an den Wänden der Gräben abgeschieden. Diese Ausräumschicht weist eine definierte und über die gesamte Tiefe der Gräben konstant bleibende Schichtdicke auf. Darüberhinaus ist die Dotierungkonzentration sowie die Schichtdicke der Ausräumschicht so eingestellt, daß die komplette, zur Kompensation benötigte Ladung bereits in dieser Ausräumschicht enthalten ist. Die Gräben können hier vorteilhafterweise einen beliebig großen Böschungswinkel aufweisen. Besonders vorteilhaft ist die Erfindung auch im Randbereich von Halbleiterbauelementen mit hoher Sperrspannungsfestigkeit.

## Beschreibung

Die vorliegende Erfindung betrifft eine Halbleiterschicht mit lateral veränderlicher Dotierung gemäß dem Oberbegriff des Patentanspruchs 1 und ein Verfahren zu dessen Herstellung gemäß dem Oberbegriff des Patentanspruchs 11. Bei der lateral veränderlichen Dotierung kann es sich dabei beispielsweise um eine lateral veränderliche Dotierungskonzentration oder aber auch um einen lateral veränderlichen Dotierungstyp handeln.

Die vorliegende Erfindung bezieht sich insbesondere auf dotierungstrukturierte Halbleiterschichten von Halbleiterbauelementen, bei denen die Dotierung dieser Halbleiterschichten durch Ätzen von Gräben und Auffüllen der Gräben mit dotiertem Halbleitermaterial erzeugt wird. Insbesondere bei Hochspannungs-Halbleiterbauelementen mit hoher Sperrspannungsfestigkeit, wie MOSFETs und IGBTs, lassen sich durch laterale Strukturierung der Bahngebiete sogenannte gepaarte Ausräumzonen und dazu komplementäre Ausräumzonen herstellen. Diese Ausräumzonen und Komplementärausräumzonen weisen typischerweise eine genau einstellbare Dotierungskonzentration auf.

Da die Ausräumzonen und Komplementärausräumzonen aufgrund ihrer hohen Dotierung eine sehr gute Leitfähigkeit aufweisen, kann gewährleistet werden, daß im Sperrbetrieb des Halbleiterbauelementes sich die Ausräumzonen und Komplementärausräumzonen gegenseitig ausräumen, wodurch eine hohe Sperrspannung erhalten bleibt. Da ferner die Gesamtmenge der Dotierung in den Ausräumzonen etwa der Gesamtmenge der Dotierung in den Komplementärausräumzonen entspricht, wird gewährleistet, daß bei einer Erhöhung der Sperrspannung die derart gebildeten pn-Übergänge zwischen den Ausräumzonen und Komplementärausräumzonen sich gegenseitig vollständig ausräumen, d. h. sich idealerweise wie eine Isolatorzone verhalten, wodurch eine sehr hohe Sperrspannung gesichert bleibt.

Die genaue Funktion sowie die Struktur und die Herstellung derartiger Ausräumzonen und Komplementärausräumzonen ist detailliert in der WO 97/29508 sowie der US 4,754,310 beschrieben und wird hiermit ausdrücklich in den Gegenstand der vorliegenden Erfindung einbezogen ("Incorporated by Reference").

Die laterale Strukturierung von Halbleiterschichten mit lateral unterschiedlicher Dotierung in der aktiven Zone von Halbleiterbauelementen mit dem Ziel einer drastischen Senkung des Flächenwiderstandes erfordert zu dessen Herstellung eine sehr aufwendige Technologie zur Ätzung und Auffüllung tiefer Gräben. Eine wichtige Anforderung, die an diese sogenannten Trench- bzw. Grabentechnologie gestellt wird, ist die Herstellung von senkrechten bis leicht schräg angeordneten Grabenwänden. Allerdings nehmen die Gräbenwände mit zunehmender Tiefe sowie bei einer hohen lateralen Ätzrate eine zunehmend gekrümmte Form an.

Selbst bei sehr exakten, anisotropen Grabenätzprozessen weisen die Gräben typischerweise eine leichte Verjüngung in die Tiefe des Halbleiterkörpers auf. Selbst bei einem verhältnismäßig geringen Böschungswinkel dieser Gräben von 89° verengt sich ein 2µm breiter Graben in einer Tiefe von 40µm bereits um 1µm. Unerwünschterweise füllt man dann die Gräben komplett auf, ergibt sich infolge der Verjüngung eine als Funktion der Tiefe quadratisch (bei runden Gräben) oder linear (bei streifenförmigen Gräben) abnehmende Flächenladungsdichte. Auf diese Weise wird jedoch eine exakte Ladungskompensation nicht mehr gewährleistet, wodurch das Sperrspannungsverhalten des Halbleiterbauelementes unerwünschterweise ebenfalls als Funktion der Tiefe abnimmt.

Eine Halbleiterschicht mit lateral veränderlicher Dotierung, bei der die lateral unterschiedlichen Dotierungen über die gesamte Tiefe der Gräben dieselbe Flächenladungsdichte aufweisen, konnte in der Praxis aufgrund des nicht zu vernachlässigenden Böschungswinkel bisher noch nicht in befriedigender Weise realisiert werden.

Ausgehend von diesem Stand der Technik ist es daher die Aufgabe der vorliegenden Erfindung, eine gattungsgemäße Halbleiterschicht mit lateral veränderlicher Dotierung anzugeben, bei der die lateral unterschiedlichen Dotierungen über die gesamte Tiefe der Gräben dieselbe Flächenladungsdichte aufweisen. Eine weitere Aufgabe der Erfindung ist es, ein Verfahren zu dessen Herstellung anzugeben.

Erfindungsgemäß werden diese Aufgaben gelöst durch eine Halbleiterschicht mit den Merkmalen des Patentanspruchs 1 und ein Verfahren mit den Merkmalen des Patentanspruchs 11.

Der besondere Vorteil der Erfindung liegt darin, daß die Grabenwände nicht mehr möglichst senkrecht angeordnete sein müssen, um eine optimale und gleichbleibende Flächenladungsdichte über die gesamte Tiefe der Gräben zu erzielen. Die Gräben können hier vielmehr einen beliebig großen Böschungswinkel aufweisen. Die Gräben werden hier nicht mehr vollständig mit dotiertem Halbleitermaterial aufgefüllt. Es wird vielmehr eine dotierte Ausräumnschicht gewissermaßen als Belag an den Wänden der Gräben abgeschieden. Diese Ausräumschicht weist eine definierte und über die gesamte Tiefe der Gräben konstant bleibende Schichtdicke auf. Darüberhinaus ist die Dotierungkonzentration sowie die Schichtdicke der Ausräumschicht so eingestellt, daß die komplette, zur Kompensation benötigte Ladung bereits in dieser Ausräumschicht enthalten ist.

Auf diese Weise ergibt sich vorteilhafterweise in Folge einer Verjüngung bei runden Gräben lediglich eine annähernd lineare Abnahme der Flächenladung als Funktion der Tiefe und bei streifenförmigen Gräben sogar eine konstante Flächenladung.

Voraussetzung hierbei ist lediglich, daß die Schichtdicke der Ausräumschicht so gering gewählt ist, daß der Graben noch an keiner Stelle zugewachsen ist.

In einer sehr vorteilhaften Weiterbildung kann insbesondere bei runden Gräben die mit zunehmender Tiefe linear abnehmende Flächenladung dadurch kompensiert werden, daß die Schichtdicke der Ausräumaschichten als Funktion der Tiefe in dem Maße zunimmt, wie die Flächenladungsdichte aufgrund des Böschungswinkels der Grabenwände abnimmt. Diese als Funktion der Tiefe zunehmende Schichtdicke kann vorteilhafterweise über eine Einprägung eines Temperaturgradienten, durch Zugabe ätzender Gase während der Abscheidung oder durch den Einbau entsprechender Rückätzschritte bewerkstelligt werden. Insbesondere kann die relative Abnahme der Flächenladung bei runden Gräben auch über den Startdurchmesser der jeweiligen Gräben und damit über ein Designmaß beeinflußt werden.

In dem oben bezeichneten Fall ist die Halbleiterschicht, in die die Gräben geätzt wurden, dotiert und bildet somit das Bahngebiet des Halbleiterkörpers. Hierbei wurden die Ausräumschichten zum Zwecke der Flächenladungskompensation in das sie umgebende Bahngebiet eingebracht. Es wäre jedoch auch denkbar, daß die Halbleiterschicht undotiert bzw. sehr schwach dotiert ist. In diesem Fall ist es besonders vorteilhaft, wenn in den Gräben zwei aneinandergrenzende Zonen mit jeweils entgegengesetzten Leitungstypen aufweist. Die eine Zone stellt das Bahngebiet dar und die jeweils andere Zone ist die Ausräumschicht zur Ladungskompensation des Bahngebietes im Sperrbetrieb. Die für eine Ladungskompensation in beiden Zonen notwendige Flächenladungsdichte läßt sich in beiden Zonen - selbst bei stark abgewinkelten Gräben - sehr exakt über deren Schichtdicken sowie deren Dotierungsdosen einstellen.

Die erfindungsgemäßen Gräben lassen sich auch besonders vorteilhaft zur Erzeugung von Randstrukturen bzw. Randabschlüssen von Halbleiterbauelementen verwenden. Dabei sollte die Flächendotierung des Bahngebietes im Sinne eines optimalen Designs des Verlaufes der Feldstärke schrittweise in Richtung Randgebiet des Halbleiterbauelementes zunehmen. Über einen im Randbereich sich radial nach außen verringernden Durchmesser der Gräben läßt sich die Ladungskompensation der Grunddotierung in der Halbleiterschicht derart abbauen, daß sich eine nach außen ansteigende Nettodotierung ergibt. Prinzipiell kann auch eine Reduzierung der Tiefe der Gräben bzw. eine als Funktion der Tiefe abnehmende Flächenladung innerhalb der Gräben zum Rand hin zu demselben Ergebnis führen.

Vorteilhafte Ausgestaltungen und Weiterbildungen der Erfindung sind Kennzeichen der Unteransprüche.

Die Erfindung wird nachfolgend anhand der in den Figuren der Zeichnung angegebenen Ausführungsbeispiele näher erläutert. Es zeigt dabei:
- Figur 1: einen Teilschnitt einer Halbleiterschicht mit einem streifenförmigen Graben, der eine an der Grabenwand angeordnete, erfindungsgemäße Ausräumschicht aufweist;
- Figur 2: ein weiteres Ausführungsbeispiel eines Teilschnitts einer Halbleiterschicht mit erfindungsgemäßer Ausräumschicht, bei der der Graben rund ausgebildet ist;
- Figur 3: ein weiteres Ausführungsbeispiel eines Teilschnitts einer Halbleiterschicht, bei der der streifenförmig ausgebildete Graben eine erste Ausräumschicht und eine zweite komplementäre Ausräumschicht aufweist;

In den Figuren der Zeichnung sind gleiche oder funktionsgleiche Elemente, sofern dies nicht anders angegeben ist, mit gleichen Bezugszeichen versehen.

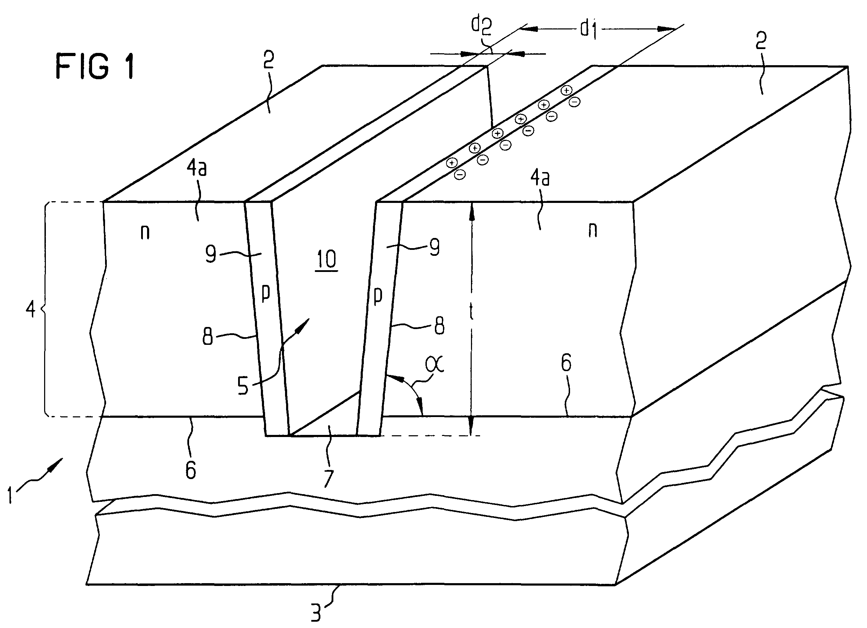

Figur 1 zeigt einen Teilschnitt einer Halbleiterschicht mit einem streifenförmigen Graben, der eine an der Grabenwand angeordnete, enfindungsgemäße Ausräumschicht aufweist.

In Figur 1 ist mit 1 ein Halbleiterkörper bezeichnet. Der Halbleiterkörper 1 weist eine erste Oberfläche 2 und eine zweite Oberfläche 3 auf. Typischerweise ist der Halbleiterkörper 1 stark dotiert, jedoch ist dessen Leitungstyp bzw. dessen Dotierungskonzentration für die weitere Erfindung nicht weiter von Belang. Zwischen der ersten Oberfläche 2 und einer Grenzfläche 6 im Halbleiterkörper 1 ist eine Halbleiterschicht 4 im Halbleiterkörper angeordnet. Im vorliegenden Ausführungsbeispiel bildet die Halbleiterschicht 4 ein n-dotiertes Bahngebiet 4a eines Halbleiterbauelementes. Die Grenzfläche 6 kann als pn-Übergang zwischen der Halbleiterschicht 4 und dem Bulkbereich des Halbleiterkörpers 1 ausgebildet sein.

Darüberhinaus sind in der Halbleiterschicht 4 eine Vielzahl von Gräben 5 Vorgesehen, von denen aus Gründen der Übersicht in Figur 1 lediglich einer dargestellt wurde. Der Graben 5 reicht von der Oberfläche 2 der Halbleiterschicht 4 durch eben diese Halbleiterschicht 4 hindurch bis in eine Tiefe t in den Halbleiterkörper 1 hinein. Es wäre selbstverständlich auch denkbar, daß der Graben 5 lediglich innerhalb der Halbleiterschicht 4 angeordnet ist. Prinzipiell ist es auch denkbar, daß die Gräben 5 von der Oberseite 2 bis zur Rückseite 3 des Halbleiterkörpers 1 durchgehen.

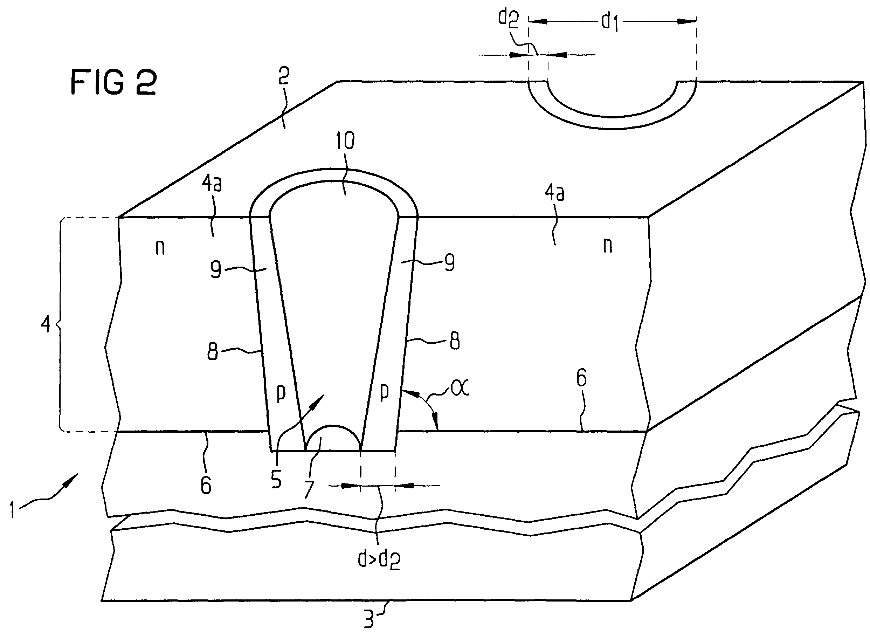

Der Graben 5 ist im Ausführungsbeispiel in Figur 1 streifenförmig ausgebildet. Die Gräben 5 können jedoch auch jede beliebige andere Form aufweisen und beispielsweise rund (siehe Figur 2), oval, rechteckig, hexagonal, gitterförmig, etc. ausgebildet sein. Der Graben 5 weist dabei einen etwa parallel zur ersten Oberfläche 2 verlaufenden Grabenboden 7 sowie Grabenwände 8 auf, die idealerweise in einem rechten Winkel zur Oberfläche 2 angeordnet sind. Typischerweise sind jedoch eben diese Grabenwände 8 in einem Böschungswinkel α gegenüber der Waagerechten abgewinkelt. Nachfolgend wird die Waagerechte durch die Ebene der ersten Oberfläche 2 und die Senkrechte durch die dazu senkrecht stehende Ebene definiert. Die Größe des Böschungswinkels α, der im vorliegenden Fall kleiner als 90° ist, sowie die Form der Gräben 5 sind jedoch für die vorliegende Erfindung nicht weiter von Belang. Die Gräben 5 können eine beliebige Form aufweisen mit einem Böschungswinkel größer oder kleiner 90°.

In Figur 1 ist innerhalb des Grabens 5 eine an den Grabenwänden 8 angeschlossene Ausräumschicht 9 vorgesehen. Die Ausräumschicht 9, die einen zum Bahngebiet 4a entgegengesetzten Leitungstyp aufweist, weist dabei im gesamten Graben 5 eine weitgehend konstante Schichtdicke d2 auf.

Nachfolgend wir ein bevorzugtes Herstellungsverfahren für die in der Halbleiterschicht angeordneten Ausräumschicht 9 beschrieben:

Eine relativ hochdotierte Halbleiterschicht vom ersten Leitungstyps, die beispielsweise durch Epitaxie, Diffusion oder Ionenimplantation hergestellt wurde, wird bereitgestellt. Nach der Strukturierung der Oberfläche 2 des Halbleiterkörpers 1 werden streifenförmiger Gräben 5 in die Halbleiterschicht 4 geätzt. Dabei kommt sowohl anisotropes Ätzen als auch isotropes Ätzen zur Herstellung der Gräben 4 in Frage. Über einen dotierenden Abscheideprozess wird eine dünne Ausräumschicht 9 vom zweiten Leitungstyp an den Grabenwänden 8 erzeugt. Bei der Herstellung der dünnen Ausräumschicht 9 wird deren Gesamtladung so eingestellt, daß sich eine Nettodotierung der Ausräumschicht 9 und des Bahngebietes 4a nahe "0" ergibt und die Flächenladung in keiner Raumrichtung die Durchbruchsladung übersteigt. Darüberhinaus muß die Schichtdicke d2 so dünn sein bzw. die Grabenbreite d1 ausreichend breit sein, daß die Ausräumschicht 9 im Graben 5 an keiner Stelle zusammenwächst. Das Zusammenwachsen der Ausräumschicht 9 am Grabenboden 7, daß zwangsläufig bei dem Abscheideprozess entsteht, kann durch einen anisotropen Ätzprozeß wieder entfernt werden.

Die Dotierungskonzentration sowie die Schichtdicke d2 der Ausräumschicht 9 ist dabei derart einzustellen, daß die Gesamtladung in der Ausräumschicht 9 etwa der Gesamtladung in dem sie umgebenden Bahngebiet 4a entspricht. Die Schichtdicke d2 und die Dotierungskonzentration der Ausräumschicht 9 lassen sich dann über die Parameter des Abscheideprozesses wie dessen Dauer, die beigefügte Dotiermenge, die Temperatur, den Prozessdruck, etc geeignet einstellen.

Abschließend wird der noch leere Zwischenraum 10 zwischen der Ausräumschicht 9 in den Gräben 5 epitaktisch aufgefüllt. Als Füllmaterial für den Zwischenraum 10 kann undotiertes Halbleitermaterial, Borphosphorsilikatglas (BPSG) oder ein ähnliches nicht dotierendes Material verwendet werden. Anstelle der Auffüllung mit epitaktisch abgeschiedenen undotiertem Silizium bzw. BPSG kann im Zwischenraum 10 der Gräben 5 auch ein Hohlraum verbleiben, sofern die Wände der Ausräumschicht 9 zu dem Zwischenraum 10 passiviert und der Zwischenraum 10 nach oben durch einen Deckel, beispielsweise aus BPSG, verschlossen wird.

Statt des oben beschriebenen Abscheidevorganges zur Herstellung der Ausräumschicht 9 kann diese auch vorteilhaft durch ein weiteres Verfahren hergestellt werden. Der Zwischenraum 10 im Graben 5 wird hierdurch epitaktisches Abscheiden von dotiertem Silizium oder Polysilizium oder Phosphorsilikatglas mit einer Dotierung vom zweiten Leistungstyp aufgefüllt. Die Dotierung kann anschließend über einen Diffusionsschritt in das umgebende Bahngebiet 4a vom ersten Leitungstyp eingetrieben werden, wodurch dort eine dünne Ausräumschicht 9 erzeugt wird. Nachfolgend wird die epitaktisch abgeschiedene Belegung wieder aus den Gräben 5 herausgeätzt. Der Zwischenraum 10 wird anschließend in bekannter Weise verschlossen. Um eine saubere Trennung der Ausräumschicht 9 und des Bahngebietes 4a zu erhalten, sollten in diesem Fall deren Dotierstoffe einen stark unterschiedlichen Diffusionskoeffizienten aufweisen.

Die Ausräumschicht 9, deren Dotierung so eingestellt wurde, daß die komplette zur Kompensation benötigte Ladung bereits in der Ausräumschicht 9 enthalten ist, bewirkt bei einem streifenförmigen Design der Gräben eine konstante Flächenladung über die gesamte Tiefe t, wodurch sich die Ladungen im Bahngebiet 4a und in der Ausräumschicht 9 im Sperrbetrieb gegenseitig ausräumen. Eine konstante Flächenladung über die gesamte Tiefe t läßt sich jedoch im wesentlichen nur bei streifenförmigen bzw. rechteckförmigen Gräben 5 erzielen. Bei rund bzw. oval ausgebildeten Gräben 5 ergibt sich jedoch in Folge der Verjüngung in die Tiefe t der Gräben 5 eine annähernd lineare Abnahme der Flächenladung als Funktion der Tiefe t. Es wäre jedoch auch wünschenswert, daß bei runden bzw. ovalen Gräben ebenfalls eine konstante Flächenladung über die gesamte Tiefe t erzielbar ist.

Diesem Sachverhalt wird anhand eines Ausführungsbeispiels gemäß Figur 2 Rechnung getragen, bei dem der Graben 5 rund ausgebildet ist. Rund ausgebildete Gräben 5 weisen eine flächendichteste Packung im Layout des Zellenfeld eines Halbleiterbauelementes auf.

Hier ist die Ausräumschicht 9 derart ausgebildet, daß deren Dicke d2 mit zunehmender Tiefe t des Halbleiterkörpers 1 ebenfalls zunimmt. Die Dicke d2 der Ausräumschicht 9 vergrößert sich mit zunehmender Tiefe t derart, daß die obengenannte lineare Abnahme der Flächenladung als Funktion der Tiefe t kompensiert wird. Auf diese Weise kann bei runden oder ovalen Gräben ebenfalls eine konstante Flächenladung über die gesamte Tiefe t der Gräben 5 gewährleistet werden. Umgekehrt sollte sich selbstverständlich bei sich in die Tiefe t verbreiternden Gräben die Dicke d2 der Ausräumschichten 9 und damit die Flächenladung entsprechend verringern.

Die optimale Einstellung der Dicke d2 der Ausräumschicht 9 läßt sich beispielsweise durch Zugabe von HCL während des Abscheidevorganges erzielen. Die Zugabe von HCL bewirkt beispielsweise, daß phosphordotiertes Silizium weniger stark geätzt wird, da der Abscheidevorgang tiefenabhängig ist. Das bedeutet, daß die Ausräumschicht 9 in oberflächennahen Gebieten stärker geätzt wird als in tieferen Bereichen des Grabens. Eine weitere Möglichkeit zur Herstellung einer variablen Dicke der Ausräumschichten 9 ist die Einstellung eines Temperaturgradienten entlang der Tiefe t der Gräben 5.

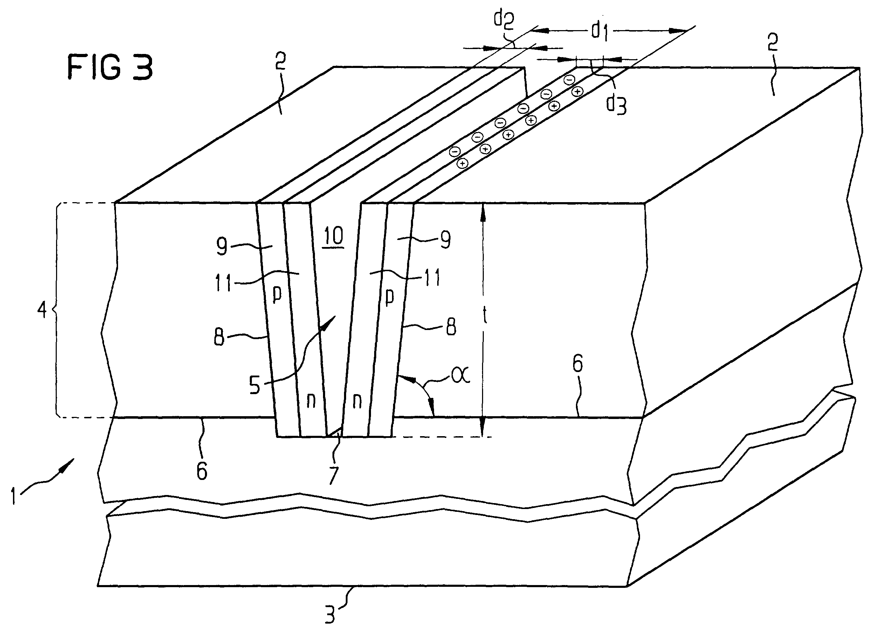

Figur 3 zeigt ein weiteres Ausführungsbeispiel eines Teilschnitts einer Halbleiterschicht 4, bei der der streifenförmig ausgebildete Graben 5 eine erste Ausräumschicht 9 und eine zweite dazu komplementäre Ausräumschicht 11 aufweist.

In Figur 3 ist die Halbleiterschicht 4 undotiert bzw. sehr schwach dotiert. Der Graben 5 weist hier eine erste Ausräumschicht 9 und eine zweite dazu komplementäre Ausräumschicht 11. Im vorliegenden Fall ist die erste Ausräumschicht p-dotiert und die zweite Ausräumschicht n-dotiert. Jeweils eine der Ausräumschichten 9, 11 bildet dann das Bahngebiet des Halbleiterbauelementes, während die andere Ausräumschicht 9, 11 zur Kompensation der Ladungen im Sperrbetrieb des Halbleiterbauelementes vorgesehen ist.

Die Ausräumschichten 9, 11 sind an den Grabenwänden 8 nebeneinander angeordnet und aneinander angeschlossen. Typischerweise, jedoch nicht notwendigerweise, weisen die beiden Ausräumschichen 9, 11 dieselbe Dotierungskonzentrationen auf. Es wäre jedoch auch denkbar, daß die Dicke d2 der ersten Ausräumschicht 9 und die Dicke d3 der zweiten Ausräumschicht 11 unterschiedlich sind. Wesentlich ist hier lediglich, daß die Gesamtladungen der beiden Ausräumschichten 9, 11 etwa gleich groß sind und sich so im Sperrbetrieb gegenseitig kompensieren.

Die Ausräumschichten 9, 11 können mittels zweier aufeinanderfolgender Prozesschritte erzeugt werden. Dabei kann die jeweilige Dotierung gemäß eines der obigen Herstellungsverfahren entweder durch einen Abscheideprozess oder durch Eintreiben der Dotierung aus einer Belegung mittels eines Diffusionsschrittes erzeugt werden. Der besondere Vorteil eines solchen Grabens 5 mit zwei dünnen Ausräumschichten 9, 11 vom entgegengesetzten Leitungstypen in einer ansonsten undotierten Halbleiterschicht 4 besteht darin, daß bei Ausfallen eines Grabens 5 durch Partikel oder Lackprobleme bei dessen Herstellung das Halbleiterbauelement voll funktionsfähig bleibt.

Bekanntlich treten Spannungsdurchbrüche bei Halbleiterbauelementen bevorzugt im Randbereich von Dotierungsgebieten auf, da dort die elektrische Feldstärke in Folge der durch den Rand bedingten Krümmung der Konzentrationsgebiete mit gleicher Dotierung abnimmt. Um derartige Spannungsdurchbrüche zu vermeiden, werden im Randbereich von Halbleiterbauelementen sogenannte Randstrukturen eingesetzt. Durch diese Randstrukturen werden lokale Feldstärkespitzen im Randbereich eines Halbleiterbauelementes vermindert. Für die Randstruktur leiten sich die entsprechenden Designparameter aus dem maximal zulässigen Feld ab und beziehen sich im wesentlichen auf die sichere Unterschreitung einer maximalen Grenzflächenladung im Bereich der vertikal verlaufenden pn-Übergänge.

Zur homogenen Erzeugung des Randbereiches werden üblicherweise die Durchmesser d1 der Gräben 5 in Richtung auf den Randbereich stetig verkleinert, wodurch sich die Gesamtmenge der Kompensationsladungen verursacht durch die Ausräumschichten 9 in den Gräben 5 ebenfalls verringert. Auf diese Weise ist ein homogener Übergang vom aktiven Bereich des Zellenfeldes des Halbleiterbauelementes zum Randbereich hin gewährleistet.

Neben der oben beschriebenen Verringerung des Durchmessers d1 der Gräben 5 in Richtung des Randbereiches wäre auch eine Variation der Form der Gräben 5 in Richtung Randbereich denkbar. Beispielsweise könnte sich der Böschungswinkel α zum Randbereich des Halbleiterbauelementes hin zunehmend verkleinern. Eine weitere Möglichkeit wäre beispielsweise die Verringerung der Tiefe t in Richtung des Randbereiches. Variiert man die Tiefe t der Gräben zum Rand hin, so kann beispielsweise die Feldstärkeverteilung im Randbereich günstig beeinflußt werden bzw. der Durchbruchsort im Sperrbetrieb des Halbleiterbauelementes festgelegt werden.

Zur Kompensation von Ladungen wird hier die Dicke d2 und die Tiefe t der Ausräumschichten 9 und damit die Dotierungsbelegung in radialer und/oder vertikaler Richtung variiert wird. Auf diese Weise kann die Form der Gräben 5 bewußt zu einer lateralen und vertikalen Variation der eingebrachten Ladungsdosis genutzt werden. Aus diese Weise läßt sich ein graduellen Übergang der Dotierung von nahezu vollständig kompensiert zu deutlich n- oder p-dotiert zu erreichen.

Die erfindungsgemäßen Gräben lassen sich besonders vorteilhaft bei einem in einem Zellenfeld angeordneten Halbleiterbauelement, beispielsweise bei einem MOSFET oder einem IGBT, verwenden. Jedoch ist die vorliegende Erfindung nicht auf die Anwendung in einem derartigen Halbleiterbauelement beschränkt, sondern kann zur definierten Einstellung der Dotierungskonzentration in einem Bahngebiet in beliebigen Halbleiterbauelementen Anwendung finden.

Darüber hinaus ist die Erfindung auch nicht ausschließlich beschränkt auf eine vollständige Kompensation der Ladungen in einem Bahngebiet 4a eines Halbleiterbauelementes, sondern es ist ein gradueller Übergang der Dotierung in einer Halbleiterschicht von nahezu vollständig kompensiert zu einer deutlichen n- oder p-Dotierung erzeugbar. Die eingebrachten Dotierungen müssen ebenfalls nicht notwendigerweise vom selben Leitungstyp sein, sondern können vielmehr auch denselben Leitungstyp, jedoch eine unterschiedliche Dotierungskonzentration aufweisen.

## Patentansprüche

1. Halbleiterschicht mit lateral veränderlicher Dotierung, mit mindestens einem in der Halbleiterschicht (4) angeordneten Graben (5), der sich von einer Oberfläche (2) bis in eine Tiefe (t) in die Halbleiterschicht (4) hinein erstreckt, und mit mindestens einer in den Gräben (5) angeordneten und an dessen Grabenwänden (8) angeschlossenen dotierten Schicht (9, 11) zur Ladungsträgerkompensation,
**dadurch gekennzeichnet,** daß
die dotierten Schichten (9, 11) eine über die gesamte Tiefe (t) der Gräben (5) weitgehend gleichbleibende Schichtdicke (d2, d3) aufweisen, wobei die doppelte Schichtdicke (d2, d3) der dotierten Schichten (9, 11) kleiner ist als der minimale Abstand (d1) der Grabenwände (8) zueinander.

2. Halbleiterschicht nach Anspruch 1,
**dadurch gekennzeichnet,** daß
die Halbleiterschicht (4) eine Dotierung vom ersten Leitungstyp aufweist und eine einzige dotierte Schicht (9) vom zweiten Leitungstyp in den Gräben (5) vorgesehen ist und, wobei die Gesamtmenge der Ladungen in der dotierten Schicht (9) und der Halbleiterschicht (4) weitgehend gleich groß ist, so daß sich im Sperrbetrieb die Ladungsträger in der dotierten Schicht (9) und der Halbleiterschicht (4) weitgehend gegenseitig ausräumen.

3. Halbleiterschicht nach Anspruch 1,
**dadurch gekennzeichnet,** daß
eine erste dotierte Schicht (9) vom ersten Leitungstyp und eine daran angeschlossene zweite dotierte Schicht (11) vom zweiten Leitungstyp vorgesehen ist, wobei die Gesamtmenge der Ladungen in den beiden dotierten Schichten (9, 11) weitgehend gleich groß ist, so daß sich im Sperrbetrieb die Ladungsträger in den beiden dotierten Schichten (9, 11) weitgehend gegenseitig ausräumen.

4. Halbleiterschicht nach Anspruch 3,
**dadurch gekennzeichnet,** daß
die Halbleiterschicht (4) undatiert ist oder eine sehr viel geringere Dotierungskonzentration als eine der dotierten Schichten (9, 11) aufweist.

5. Halbleiterschicht nach einem der vorhergehenden Ansprüche,
**dadurch gekennzeichnet,** daß
die Gräben (5) in der Projektion auf die Ebene der ersten Oberfläche (2) streifenförmig und/oder rechteckig ausgebildet sind.

6. Halbleiterschicht nach einem der vorhergehenden Ansprüche,
**dadurch gekennzeichnet,** daß
die Gräben (5) in der Projektion auf die Ebene der ersten Oberfläche (2) kreisförmig und/oder oval ausgebildet sind.

7. Halbleiterschicht nach Anspruch 6,
**dadurch gekennzeichnet,** daß
die Schichtdicken (d2) der dotierten Schicht (9) als Funktion der Tiefe (t) der Gräben (5) derart zunehmen oder abnehmen, daß die Abnahme bzw. die Zunahme der flächenbezogenen Ladung als Funktion der Tiefe (t) kompensiert wird.

8. Halbleiterschicht nach einem der vorherigen Ansprüche
**dadurch gekennzeichnet,** daß
die Halbleiterschicht (4) in einem Halbleiterbauelement mit hoher Sperrspannungsfestigkeit angeordnet ist und das Halbleiterbauelement ein niederohmiges Bahngebiet (4a) aufweist.

9. Halbleiterbauelement nach Anspruch 8,
**dadurch gekennzeichnet,** daß
die in die Halbleiterschicht (4) eingebrachten Ladungsdosis in einem Randbereich des Halbleiterbauelementes über die Schichtdicke (d2) der Ausräumzonen (9) und/oder deren Durchmesser (d1) und damit über die Dotierungsbelegung in radialer Richtung variiert wird.

10. Halbleiterbauelement nach einem der Ansprüche 8 oder 9,
**dadurch gekennzeichnet,** daß
die in die Halbleiterschicht (4) eingebrachten Ladungsdosis in einem Randbereich des Halbleiterbauelementes über die Tiefe (t) der Gräben (5) und/oder deren Durchmesser (d1) und damit über die Dotierungsbelegung in vertikaler Richtung variiert wird.

11. Verfahren zur Herstellung einer dotierten Schicht in einer Halbleiterschicht nach einem der vorhergehenden Ansprüche,
**gegennzeichnet durch**
folgende Verfahrensschritte:
(a) Ein Halbleiterkörper (1) mit einer Halbleiterschicht (4) wird bereitgestellt;
(b) in die Halbleiterschicht (4) werden Gräben (5) geätzt;
(c) über einen dotierenden Abscheideprozeß mit vorgegebener Dotierdosis wird an den Grabenwänden (8) eine dotierte Schicht (9, 11) vom ersten Leitungstyp (8) erzeugt;
(d) der Abscheideprozeß dauert dabei solange, bis eine vorgegebene Schichtdicke (d2) der dotierten Schicht (9, 11) erreicht ist;
(e) je nach der Anzahl der aneinander angeschlossenen dotierten Schichten (9, 11) werden die Verfahrensschritte (c) und (d) entsprechend oft durchgeführt, wobei bei jedem neuen Abscheidevorgang jeweils ein Halbleitermaterial vom entgegengesetztem Leitungstyp abgeschieden wird.

12. Verfahren nach Anspruch 11,
**gekennzeichnet durch**
folgende Verfahrensschritte:
(a) Ein Halbleiterkörper (1) mit einer Halbleiterschicht (4) wird bereitgestellt;
(b) in die Halbleiterschicht (4) werden Gräben (5) geätzt;
(c) die Gräben (5) werden durch Abscheiden eines dotierten, nicht notwendigerweise leitenden Materials mit vorgegebener Dotierdosis vom ersten Leitungstyp aufgefüllt;
(d) über einen Diffusionsprozeß werden die Dotierstoffe des Materials über die Grabenwände (8) in die Halbleiterschicht (4) solange eingetrieben, bis eine dotierte Schicht (9) mit vorgegebener Schichtdicke (d2) erreicht ist;
(e) die Schichtdicke (d2) ist dabei über die Dotierdosis und/oder die Zeitdauer des Diffusionsprozesses und/oder dessen Temperatur einstellbar;
(f) nach dem Diffusionsprozeß wird das abgeschiedene Material in den Gräben (5) wieder herausgeätzt.

13. Verfahren nach einem der Ansprüche 11 oder 12,
**dadurch gekennzeichnet,** daß
nach der Herstellung der dotierten Schichten (9, 11) ein verbleibener Zwischenraum (10) in den Gräben (5) über einen weiteren Abscheideprozeß mit undotiertem Material wieder aufgefüllt wird.

14. Verfahren nach einem der Ansprüche 11 oder 12,
**dadurch gekennzeichnet,** daß
nach der Herstellung der dotierten Schicht die Grabenwände passiviert werden und anschließend ein Deckel aus undotiertem Material auf den verbleibenden Zwischenraum in den Gräben (5) erzeugt wird.

15. Verfahren nach einem der Ansprüche 13 oder 14,
**dadurch gekennzeichnet,** daß
als undotiertes Material polykristallines Silizium und/oder Borphosphorsilikatglas (BPSG) und/oder Quarzglas verwendet wird.

16. Verfahren nach einem der Ansprüche 11 bis 15,
**dadurch gekennzeichnet,** daß
der Abscheidevorgang zur Herstellung der dotierten Schichten (9, 11) in einer leicht selektiv ätzenden Atmosphäre erfolgt.
